Europäisches Patentamt

European Patent Office

Office européen des brevets

(19)

(11) **EP 0 651 508 B1**

(12) **EUROPEAN PATENT SPECIFICATION**

(45) Date of publication and mention
of the grant of the patent:
**11.03.1998 Bulletin 1998/11**

(21) Application number: **94903893.9**

(22) Date of filing: **29.12.1993**

(51) Int Cl.6: **H03K 17/74**

(86) International application number:
**PCT/ES93/00102**

(87) International publication number:
**WO 94/17593 (04.08.1994 Gazette 1994/18)**

(54) **FAST BIDIRECTIONAL ANALOG SWITCHING SYSTEM FOR HF PULSES OF INSTANTANEOUS HIGH POWER**

SCHNELLER BIDIREKTIONALER ANALOGER SCHALTER FÜR HF-IMPULSE MIT HOHER MOMENTANER LEISTUNG

SYSTEME DE COMMUTATION ANALOGIQUE BIDIRECTIONNEL RAPIDE POUR IMPULSION HF DE HAUTE PUISSANCE INSTANTANEE

(84) Designated Contracting States:
**AT BE CH DE DK ES FR GB GR IE IT LI LU MC NL PT SE**

(30) Priority: **28.01.1993 ES 9300154**

(43) Date of publication of application:
**03.05.1995 Bulletin 1995/18**

(73) Proprietor: **CONSEJO SUPERIOR DE INVESTIGACIONES CIENTIFICAS E-28006 Madrid (ES)**

(72) Inventors:
• **RAMOS FERNANDEZ, Antonio, E-28020 Madrid (ES)**
• **SANZ SANCHEZ, Petro Tomás, 28043 Madrid (ES)**

(74) Representative: **Ungria Lopez, Javier et al Avda. Ramon y Cajal, 78 28043 Madrid (ES)**

(56) References cited:
**FR-A- 2 612 023**          **GB-A- 2 033 181**
**GB-A- 2 139 835**          **US-A- 4 019 069**
**US-A- 4 742 249**

• **PATENT ABSTRACTS OF JAPAN vol. 5, no. 163 (E-78) 20 Octubre 1991 & JP,A,56 090 625 (HITACHI MEDICAL CORP) 22 Julio 1991**
• **PATENT ABSTRACTS OF JAPAN vol. 013, n m. 378 (E-809) 22 Agosto 1989 & JP,A,01 128 617 (MITSUBISHI ELECTRIC CORP) 22 Mayo 1989**
• **PATENT ABSTRACTS OF JAPAN vol. 006, n m. 077 (E-106) 14 Mayo 1982 & JP,A,57 015 532 (MITSUBISHI ELECTRIC CORP) 26 Enero 1982**
• **A. Ramos et al., "A 5 MHz high-voltage demultiplexed ultrasonic array system for rapid-scan testing of advanced materials", Sensors and Actuators A, 37-38 (1993) 385-390**

## Description

The invention relates to the field of switching of wide band pulses and to switches using semiconductor devices (H03B 11/10).

The purpose of this system is electronic switching of high voltage short duration monopolar pulses with very short transition times, whose spectrum consequently contains a great portion of high frequencies.

The operability of the system, depending on the actual realization and on the load impedances connected to its terminals, can reach up to 900 V and 50 MHz.

The analog switching channel permits the passing of high voltage monopolar pulses in both directions and is capable, until a certain voltage amplitude threshold, of switching long duration bipolar signals, presenting in its conducting state a notably low series impedance (in the order of 1 Ohm).

This system applies more particularly and immediately to systems for controlling wide band equipments which operate with high frequency radiations and need switching of high voltage and medium power pulses (medical echography, non-destructive evaluation of materials) or of pulses of high currents and high instantaneous powers (ultrasonic lithotripsy, echographic inspection of strongly attenuating industrial structures).

The importance of a switching system with these characteristics is based on that it offers good services simultaneously in various aspects that are normally opposed to each other in the bidirectional switching devices presently available:

- Maximum peak amplitude allowed in the switched currents and voltages.

- Turn-on time and available bandwidth of the switching channel.

- Series impedance in the conducting state.

To this should be added the advantage that the control of the system does not require the use of high voltage sources.

In analog switching applications, there has until now been used methods based on the following devices: electromechanical relays, bipolar transistors, thyristors, triacs and, more recently, DMOS and VMOS transistors. Each of these devices presents limitations in its functionability when fast switching of high voltage pulses of high instantaneous currents is required (for example with capacitive loads) and under wide band conditions.

- The electromechanical relays offer an initially very low series resistance in the connection state, but it varies with the intensity of the current, an aspect which degrades hastily with the use of the relays. This makes these devices not very adequate for use in the aforementioned applications, which generally require the realization of several thousands of switchings per second. To this should be added the considerable activation times of these devices, which in the most rapid versions are in the order of millisecond, and also the limitations caused by the mechanical bouncing of their contacts.

- The switches based on bipolar transistors should be controlled by means of the base current, which considerably perturbs the switched analog signal, and additionally they require to use of expensive power sources with voltages higher than the instantaneous peak voltage which one desires to switch.

- The combinations of thyristors and triacs permit high powers to be managed, but introduce too much offset voltage and too many nonlinear effects [Siliconix, "Don't Trade Off Analog Switch Spec"-MOS POWER Design catalog -AN77-2, pp. 6-43/6-48, Santa Clara, California, 1983]. In addition, they present some practical inconveniencies in high frequency applications: excessive temporal tolerances in the switching, long turn-off time and introduction of transients which degrade the switched signal, which very notably reduces the corresponding dynamic range.

- The analog switches based on DMOS technology [J.D. Plummer et al., "Two-Dimensional Transmit/ Receive Ceramic Piezoelectric Arrays: Construction and Performance", IEEE Trans. Sonic and Ultrason. Vol. SU-25, No 5, pp. 273-280, 1978] allow their integration in reduced size chips [P. Harold, "Improved analog switches and multiplexers bring benefits to old and new applications", EDN. May 14. pp. 65-74, 1987]; There exists a wide range of these devices, commercialized by different companies among which the following ones could be emphasized: Analog Devices Inc., Intersil, Maxim I.P., and Siliconix Inc. These devices generally present low distortion and a good frequency response, but in spite of the continuous innovations introduced by different manufacturers, especially by Siliconix, the maximum peak voltage that can be switched is about 60 volts, and the resistances in the conducting state are in the order of 40 or 50 ohms, which seriously limits the maximum allowable current.

- Finally, the switching systems based on VMOS power transistors, proposed by some authors [Siliconix, "Don't Trade Off Analog Switch Spec" -MOS POWER Design catalog -AN77-2, pp. 6-43/6-48, Santa Clara, California, 1983], allow the switching of until 10 watts, linearly, with low ON impedance and very reduced distortion, thanks to the purely resistive characteristics of the drain-sourse channel. However, they only permit the switching of positive pulses, as they practically turn into a short circuit for negative voltages from -0.6 volts. Some solutions to this problem involve several VMOS transistors in relatively complex circuits which notably raises the costs of the switching process, especially in multichannel type applications (Acustical Imaging, Ultrasonic Tomography), [J.F. Gelly and C. Maerfeld, "Properties for a 2D Multiplexed Array for Acoustic Imaging", IEEE Ultrasonics Symp. Proc., pp 685-689, 1981; D.W. Fitting et al., "A Two-Dimensional Array Receiver for Reducing Refraction Artifacts in Ultrasonic Computed Tomography of Attenuation", IEEE Trans. Ultrason. Ferroel. Freq. Control, Vol. UFFC-34, No 3, pp. 346-356, 1987]. Even though this type of switches can control fairly high currents (thanks to their low ON resistance), they present limitations similar to those of the switches based on DMOS transistors in what regards the maximum switchable voltage and the necessity of bias sources with voltages superior to the peak amplitudes of the pulses which are to be switched.

JP-A-56-090625 discloses a switch circuit for exciting an ultrasonic wave oscillator. A diode long in reverse recovery time, *i.e.,* large in Hall storage effect, is used as a switching element. A positive voltage lower than the input voltage is applied to a control terminal.

FR-A-2 612 023 discloses a circuit for switching VHF and UHF signals with a power content of several tens or hundreds of watts. The circuit of FR-A-2 612 023 corresponds essentially to the preamble of claim 1 of the present application.

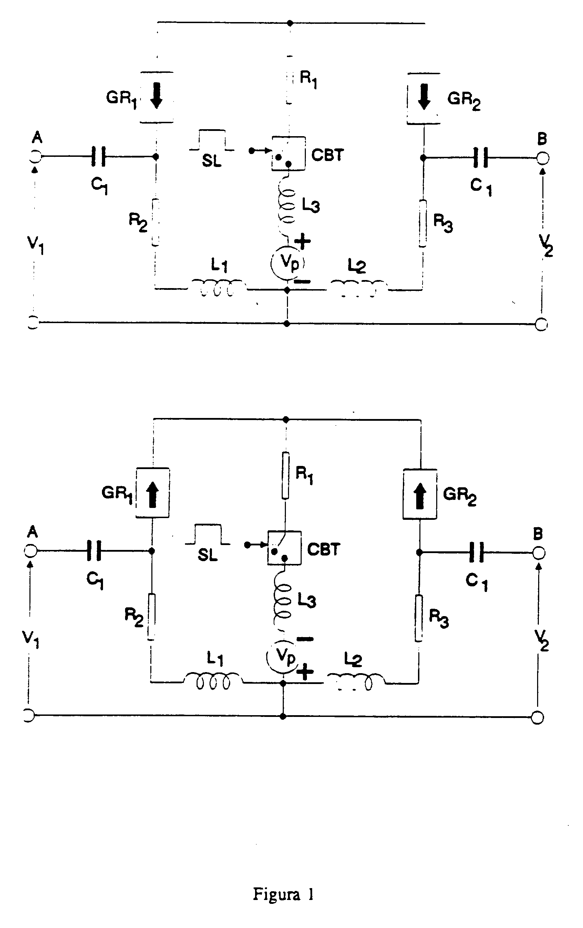

The basic principle of the procedure object of the present invention is outlined in figure 1, in which two functional diagrams are shown which solely differ in the polarity of the power source which produces the voltage Vp, and in the orientation of the rectifier sets $GR_1$ and $GR_2$.

The main conductor channel A-B for the switching of the power pulse is formed by the connection in series of two high voltage capacitors $C_1$ and two rectifier steps $GR_1$ and $GR_2$ capable of tolerating high voltages when breaking and oriented in contrary directions in what regards the conduction of current. In the figure, two possible configurations of the system are presented, according to the polarity chosen for the source $V_p$.

The rectifier sets $GR_1$ and $GR_2$ can be formed by any parallel-series combination of semiconductor devices with rectifying characteristics; the only conditions requirable are the contrary orientation of the two rectifier steps and, in the case of high voltage input pulses, that the rectifiers present a reverse storage time superior to the width of the pulse to be switched, which is fulfilled in a great number of devices commercially available.

In the off state, i.e. when the circuit is open because so is the switch CBT, the channel A-B presents high impedance for any bipolar signal, $V_1$ and $V_2$, connected to any of the main terminals of the switch.

The transition to the conducting state is achieved by means of closing an unidirectional current switch of conventional type, CBT, of low voltage (in the order of 20-40 V), which, therefore, can be controlled by a logic signal SL from conventional TTL or CMOS logic circuits. The closing of the switch CBT gives rise to the passing of a continuous current through the central branch and $GR_1$ and $GR_2$ from a low voltage source $V_p$ (preferably less than 50 V) with the adequate polarity according to the connection chosen from the two possible ones for the rectifier steps. This current is established through the inductance $L_3$, the resistance $R_1$ and the two series networks formed by the rectifier ($GR_1$ or $GR_2$), the resistance ($R_2$ or $R_3$), and the inductance ($L_1$ or $L_2$), corresponding to each of the lateral branches of the circuit. Under these conditions, the main channel A-B of the circuit allows the passing of pulses with peak voltages much higher than $V_p$ (in the order of 100 to 800 V), as long as their duration does not exceed the reverse storage time of $GR_1$ and $GR_2$ and, as long as the conducting state lasts, of any associated signal of long duration and low voltage with peak-to-peak amplitudes inferior to a voltage in the order of $V_p/2$ (which depends on the values chosen for the resistances $R_1$, $R_2$ and $R_3$).

The switching system, object of the present invention, is constituted by a main conductor channel and of two secondary polarizing low voltage circuits (for the activation of the main conductor channel) composed of three branches symmetrically connected to the intermediate nodes of the main channel, which is formed by the series connection of two high voltage capacitors connected to the two external terminals of the channel, and of two rectifier sets oriented so that their connection to the central point of the channel interconnects the terminals of each set with the same polarity. The voltage $V_p$ of the polarization source in the central branch can have a nominal value at least one order of magnitude inferior to the maximum switchable peak voltage.

The two rectifier sets, included in the switching channel, must have a reverse storage time superior to the duration of the high voltage pulses switchable through them; these groups can be formed by different combinations of circuits with suitable rectifying characteristics, based on semiconductors such as diodes, bipolar transistors, thyristors, triacs or MOS transistors, grouped in series or in parallel, so as that, by adding new components of this type in series or parallel connection, the maximum switchable voltage or current can be increased.

The three branches of the polarization circuits contain inductive reactances connected in series with resistances, in order to obtain high values of input impedance at the terminals of the switch, which makes the application of the switch possible in multichannel type configurations.

When with the high voltage pulsed signal (typically in the order of 100 to 800 V) is associated (in the same pulse train or as an answer to this signal) a low voltage one, whose peak value does not exceed a threshold val-

ue, $V_u$, of an order of magnitude given by the expression

$$V_u = V_p/(1 + R_1/R_3 + R_1/R_2)$$

the main switching channel does not present any limitation in the temporal duration allowed for the switched signal, *i.e.*, the signal will pass as long as there exists a conducting state through the two rectifier sets, even though its duration has surpassed the reverse storage time of them.

This feature is very adecuate for transceiver systems such as pulse-echo systems, in which their limited pass band gives rise to, in the reception stage, low amplitude signals but with a duration far greater than the duration of the pulse used for their high voltage excitation. The bidirectional behaviour of the switch, object of the present invention, is thus suitable for this kind of applications.

The choice of sufficiently high values for $C_1$, for example 100 nF, guarantees a perfect isolation of the switched signals with respect to the polarization circuits, without introducing substantial distortions into these signals. The incorporation of these series capacitors in the ends of the conduction channel, with impedances in the radio frequency range several orders of magnitude inferior to the impedances of the polarization branches and of the switched load, makes possible the switching of signals with very long duration as long as the total peak-to-peak amplitude of these signals does not exceed twice the voltage threshold $V_u$ determined by the indicated formula.

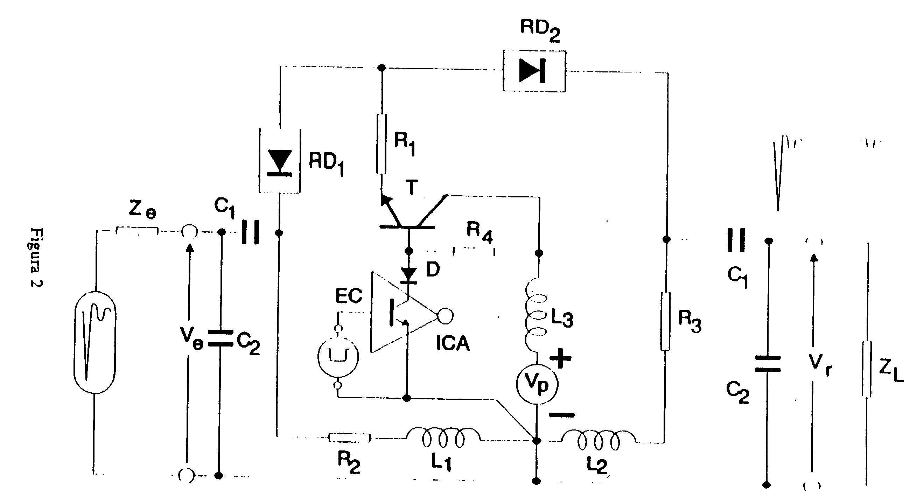

In figure 2 one way to materialize the present invention is shown in detail. The circuit shown in this figure permits the direct control of the switching channel by means of a control input (EC) activated by logic signals of the TTL type. In this case, the current switch CBT is materialized by means of a logic inverter circuit with open collector output (ICA), for example 1/6 of the chip 7406, connected through a diode D to the base of the NPN type transistor T which, because of its polarization from the collector through the resistance $R_4$, supplies the continuous current necessary for activating the power channel. The rectifier sets $GR_1$ and $GR_2$ are implemented by means of two diode networks $RD_1$ and $RD_2$.

The circuit includes the capacitors $C_2$ (whose capacity is at least two orders of magnitude less than the capacity of the capacitors $C_1$), in parallel with the input impedances $Z_e$ y $Z_L$. The purpose of this is to minimize the dependency of the leakage currents during the non-active phases of the main channel with these impedances.

The conductor channel $C_1$-$RD_1$-$RD_2$-$C_1$ permits, when it is active, the reception at terminals of the input capacitor $C_2$ of echo signals $V_r$ originating from active loads $Z_L$ (for example of piezoelectric type), as a response to their previous excitation by means of the transmission of a pulse $V_e$ with high instantaneous pow-

er through said channel.

The main advantages of the present invention in comparison with alternative procedures are summarized under the following points:

- Its capacity for switching high voltages, in the order of several hundreds of volts, without using mechanical type contacts or high voltage bias sources.

- Its low series impedance during conduction, which is not degradable during long time use, in combination with its short activation time allows switching of high currents (several amperes in the case of a typical materialization) in a wide radio frequency range, and with high pulse repetition rates.

This circuit, fitting conveniently the values of the resistances, capacitors and inductances to the loads $Z_e$ y $Z_L$, allows the control, from a low voltage source $V_p$, of the switching of short impulses $V_e$, normally shorter than 1 microsecond, with high peak voltages and currents, which can be adjusted optimally in each application by using a sufficient number of diodes with appropriate characteristics in each RD network.

## Description of the drawings

Figure 1. Basic principle of the switching system.

| | |
|---|---|
| A,B ........ | Access terminals to the switching channel. |
| $V_1$, $V_2$..... | Voltage between the terminals A, B and ground, respectively. |
| $C_1$.......... | High voltage capacitors. |
| $R_1$, $R_2$, $R_3$.. | Electrical resistances. |
| $L_1$, $L_2$, $L_3$.. | Inductances. |
| $GR_1$, $GR_2$.... | Rectifier sets mono or multi- component, connected to the resistance $R_1$ either through their anodes or through their cathodes. |
| CBT......... | Low voltage switch. |
| $V_p$.......... | Low voltage source for polarization of the switching channel by means of closing the switch CBT. The polarity (+,-) of this source is determined by the direction chosen for the flow of continuous current in $GR_1$ and $GR_2$. |
| SL.......... | Input logic signal for the control of the switch. |

Figura 2. A practical realization of the invention, which can be controlled digitally by means of TTL pulses.

| | |
|---|---|
| $V_e$......... | High voltage excitation pulse. |
| $V_r$......... | Echo voltage received as a response to $V_e$. |
| $Z_e$......... | Output impedance of the generator of |

the pulse $V_e$.

| | |
|---|---|
| $Z_L$.......... | Load impedance. |
| $C_1$, $C_2$...... | Electrical capacitors. |
| $R_1$,$R_2$,$R_3$,R4. | Electrical resistances. |
| $L_1$, $L_2$, $L_3$.. | Inductances. |
| $RD_1$, $RD_2$, .. | Diode networks based on series and/or parallel connections. |
| T........... | Low voltage high frequency NPN transistor. |
| D........... | Rectifier diode. |
| $V_p$.......... | Low voltage source. |
| ICA........ | Logic inverter with open collector output. |
| EC.......... | Control input, adapted to TTL type logic. |

## Claims

1. Fast bidirectional analog switching system for electrical signals of high instantaneous power, comprising:

a main conductor channel (A - B) for transmitting the signals in an ON-state of the switching system and isolating the signals applied at an input from an output in an OFF-state of the system,

two secondary circuits, each formed by a lateral branch and a central branch, the central branch being a common branch shared by both secondary circuits, the two lateral branches being symmetric and including inductive reactances ($L_1$, $L_2$) connected in series with resistances ($R_2$, $R_3$);

the main conductor channel including two rectifier sets ($GR_1$, $GR_2$) formed by semiconductor devices and connected in series and in opposite directions which permit, upon application of a current thereto, the main conductor channel to conduct the signals in both directions,

the common branch of both secondary circuits including an inductive reactance ($L_3$) coupled to the point of inter-connection between the two rectifier sets ($GR_1$ ,$GR_2$);

**characterized in that**

the common branch further includes an unidirectional low voltage switch (CBT) controlled by a logic signal (SL) which provides, together with a low voltage source (Vp), connected thereto via the inductive reactance ($L_3$) for the generation of the current applied to the rectifier sets; said switch (CBT) being open in the OFF-state;

the rectifier sets ($GR_1$,$GR_2$) and the common branch being adapted to permit in the ON-state conduction of HF high voltage pulses with peak voltages of both polarities superior to the voltage Vp of the voltage source (Vp) under the condition that the duration of the pulses does not exceed the reverse storage time of the rectifier sets ($GR_1$, $GR_2$),

the common branch further includes a resistor ($R_1$) which is connected between the low voltage switch (CBT) and the point of interconnection between the two rectifier sets ($GR_1$,$GR_2$) to provide a high impedance with respect to the reference potential of the high voltage pulses in the ON-state as well as in the OFF-state, and

the main conductor channel further includes two capacitors ($C_1$,$C_1$) connected in series with the rectifier sets ($GR_1$,$GR_2$).

2. Fast bidirectional analog switching system according to claim 1, wherein the low voltage source provides a voltage $V_p$ of less than 50 V.

3. Fast bidirectional analog switching system according to claim 1 or 2, wherein the HF high voltage pulse has a peak voltage of 100 V to 800 V and a duration of less than 1 microsecond.

4. Fast bidirectional analog switching system according to any of the preceding claims, wherein the system is arranged so that, when at the input together with the high voltage pulse, in the same train as said high voltage pulse or as a response to said pulse, appear other external signals of lower voltage, whose peak values do not exceed a threshold $V_u$, of an order of magnitude given by the expression

$$V_u=V_p/(1+R_1/R_3+R_1/R_2),$$

the system is capable of switching said signals independently of their duration, that is, the signals can continue passing in both directions, as long as there persists the conducting state through the rectifier sets ($GR_1$, $GR_2$), even if the interval of existence of these signals has exceeded the reverse storage time of said rectifier sets, $V_p$ representing the voltage of the voltage source ($V_p$) of the common branch, $R_1$ representing the value of the resistance of the common branch, and $R_2$ and $R_3$ representing the value of the resistances of the lateral branches.

5. Fast bidirectional analog switching system according to any of the preceding claims, wherein the control of its conducting state is performed from TTL or CMOS logic levels, using a logic inverter with open-collector output coupled by a diode (D) to the base of a bipolar transistor (T) which works as the low voltage switch in the common branch of the two secondary circuits.

**6.** Fast bidirectional analog switching system according to any of the preceding claims, wherein at each end of the main conductor channel (A-B) there is a second capacitor ($C_2$) which is connected between the input end of said first capacitor ($C_1$) and ground, said second capacitor ($C_2$) being of a capacity of at least two orders of magnitude less than the capacity of said first capacitor ($C_1$).

## Patentansprüche

**1.** Schnelles bidirektionales, analoges Schaltersystem für elektrische Signale mit hoher, momentaner Leistung, umfassend:

einen Hauptleiterkanal (A-B) zur Übertragung von Signalen in einem EIN-Zustand des Schaltersystems und zum Trennen der Signale, die an einen Eingang von einem Ausgang in einem AUS-Zustand des Systems angelegt werden,

zwei sekundäre Schaltungen, von denen jede durch einen Seitenzweig und einen Hauptzweig gebildet ist, wobei der Hauptzweig ein gemeinsamer Zweig ist, der von beiden sekundären Schaltungen gemeinsam benutzt wird, die zwei Seitenzweige symmetrisch sind und induktive Reaktanzen ($L_1$, $L_2$) einschließen, die in Reihe mit Widerständen ($R_2$, $R_3$) verbunden sind;

der Hauptleiterkanal zwei Gleichrichtergruppen ($GR_1$, $GR_2$) einschließt, die von Halbleitereinrichtungen gebildet und in Reihe und in entgegengesetzten Richtungen verbunden sind, was beim Anlegen eines Stroms daran erlaubt, daß der Hauptleiterkanal die Signale in beide Richtungen leitet,

der gemeinsame Zweig beider sekundären Schaltungen eine induktive Reaktanz ($L_3$) einschließt, die mit dem Verbindungspunkt zwischen den zwei Gleichrichtergruppen ($GR_1$, $GR_2$) gekoppelt ist;

**dadurch gekennzeichnet,** daß

der gemeinsame Zweig des weiteren einen unidirektionalen Niederspannungsschalter (CBT) einschließt, der von einem logischen Signal (SL) gesteuert wird, und zusammen mit einer Niederspannungsquelle ($V_p$), die damit über

die induktive Reaktanz ($L_3$) verbunden ist, die Erzeugung des an die Gleichrichtergruppen angelegten Stroms liefert; der genannte Schalter (CBT) in dem AUS-Zustand offen ist;

die Gleichrichtergruppen ($GR_1$, $GR_2$) und der gemeinsame Zweig fähig sind, in dem EIN-Zustand die Leitung von HF Hochspannungsimpulsen mit Spitzenspannungen beider Polaritäten, die höher als die Spannung Vp der Spannungsquelle ($V_p$) sind, unter der Bedingung zu erlauben, daß die Dauer der Impulse nicht die Sperrspeicherzeit der Gleichrichtergruppen ($GR_1$, $GR_2$) überschreitet,

der gemeinsame Zweig des weiteren einen Widerstand ($R_1$) einschließt, der zwischen dem Niederspannungsschalter (CBT) und dem Verbindungspunkt zwischen den zwei Gleichrichtergruppen ($GR_1$, $GR_2$) verbunden ist, um eine hohe Impedanz in bezug auf das Bezugspotential der Hochspannungsimpulse in dem EIN-Zustand sowie in dem AUS-Zustand bereitzustellen, und

der Hauptleiterkanal des weiteren zwei Kondensatoren ($C_1$, $C_1$) einschließt, die in Reihe mit den Gleichrichtergruppen ($GR_1$, $GR_2$) verbunden sind.

**2.** Schnelles, bidirektionales, analoges Schaltersystem gemäß Anspruch 1, worin die Niederspannungsquelle eine Spannung $V_p$ von weniger als 50 V liefert.

**3.** Schnelles, bidirektionales, analoges Schaltersystem gemäß Anspruch 1 oder 2. worin der HF Hochspannungsimpuls eine Spitzenspannung von 100 V bis 800 V und eine Dauer von weniger als 1 Mikrosekunde aufweist.

**4.** Schnelles, bidirektionales, analoges Schaltersystem gemäß irgendeinem der vorhergehenden Ansprüche, wobei das System so angeordnet ist, daß, wenn an dem Eingang zusammen mit dem Hochspannungsimpuls in dem gleichen Zug wie der genannte Hochspannungsimpuls oder als eine Reaktion auf den genannten Impuls andere exteme Signale niederer Spannung erscheinen, deren Spitzenwerte eine Schwelle $V_u$, mit einer Größenordnung nicht überschreiten, die durch den Ausdruck gegeben ist

$$V_u = V_p/(1 + R_1/R_3 R_1/R_2)$$

das System fähig ist, die genannten Signale unabhängig von ihrer Dauer zu schalten, d.h., die Signale können fortfahren, in beide Richtung zu gehen, solange der Leitungszustand durch die Gleichrichtergruppen (GR$_1$, GR$_2$) andauert, selbst wenn das Intervall des Vorhandenseins dieser Signal die Sperrspeicherzeit der genannten Gleichrichtergruppen überschritten hat, wobei V$_p$ die Spannung der Spannungsquelle (V$_p$) des gemeinsamen Zweiges darstellt, R$_1$ den Widerstandswert des gemeinsamen Zweiges darstellt und R$_2$ und R$_3$ die Widerstandswerte der seitlichen Zweige darstellen.

5. Schnelles, bidirektionales, analoges Schaltersystem gemäß irgendeinem der vorhergehenden Ansprüche, wobei die Steuerung seines Leitungszustands von TTL oder CMOS Logikpegeln ausgeführt wird, wobei eine logische Umkehrschaltung mit einem offenen Kollektorausgang verwendet wird, der durch eine Diode (D) mit der Basis eines bipolaren Transistors (T) verbunden ist, der als der Niederspannungsschalter in dem gemeinsamen Zweig der zwei sekundären Schaltungen arbeitet.

6. Schnelles, bidirektionales, analoges Schaltersystem gemäß irgendeinem der vorhergehenden Ansprüche, wobei an jedem Ende des Hauptleiterkanals (A-B) ein zweiter Kondensator (C$_2$) ist, der zwischen dem Eingangsende des genannten ersten Kondensators (C$_1$) und Masse verbunden ist, wobei der genannte zweite Kondensator (C$_2$) eine Kapazität von wenigstens zwei Größenordnungen kleiner als die Kapazität des genannten ersten Kondensators (C$_1$) hat.

**Revendications**

1. Système de commutation analogique bidirectionnel rapide pour signaux électriques de haute puissance instantanés, comprenant :

un canal conducteur principal (A - B) pour transmettre les signaux dans un état de MARCHE du système de commutation et pour isoler les signaux, appliqués à une entrée, d'une sortie dans un état d'ARRET du système ;
deux circuits secondaires, formés chacun d'une branche latérale et d'une branche centrale, la branche centrale étant une branche commune partagée par les deux circuits secondaires, les deux branches latérales étant symétriques et comprenant des réactances inductives (L$_1$, L$_2$) connectées en série avec des résistances (R$_2$, R$_3$)
le canal conducteur principal comprenant deux ensembles de redresseurs (GR$_1$, GR$_2$) formés par des dispositifs à semi-conducteurs et connectés en série et dans des directions opposées qui permettent, lorsqu'on leur applique un courant, au canal principal de conduire les signaux dans les deux directions ;
la branche commune aux deux circuits secondaires comprenant une réactance inductive (L$_3$) couplée au point d'interconnexion entre les deux ensembles de redresseurs (GR$_1$, GR$_2$) ;

caractérisé en ce que

la branche commune comprend, de plus, un commutateur de tension basse unidirectionnel (CBT) contrôlé par un signal logique (SL) qui assure, avec une source de tension basse (V$_p$), connectée à celui-ci via la réactance inductive (L$_3$), la génération du courant appliqué aux ensembles de redresseurs ; ledit commutateur (CBT) étant ouvert dans l'état d'ARRET ;
les ensembles de redresseurs (GR1, GR2) et la branche commune sont destinés à permettre, dans l'état de MARCHE, la conduction d'impulsions HF de tension élevée avec des tensions de crête des deux polarités supérieures à la tension Vp de la source de tension (Vp) à condition que la durée des impulsions ne dépasse pas le temps de stockage inverse des ensembles de redresseurs (GR1, GR2) ;
la branche commune comprend, de plus, une résistance (R$_1$) qui est connectée entre le commutateur de tension basse (CBT) et le point d'interconnexion entre les deux ensembles de redresseurs (GR$_1$, GR$_2$) pour fournir une haute impédance par rapport au potentiel de référence des impulsions de tension élevée dans l'état de MARCHE ainsi que dans l'état d'ARRET ; et
le canal conducteur principal comprend, de plus, deux condensateurs (C$_1$, C$_1$) connectés en série avec les ensembles de redresseurs (GR$_1$ GR$_2$).

2. Système de commutation analogique bidirectionnel rapide selon la revendication 1, dans lequel la source de tension basse fournit une tension V$_p$ inférieure à 50 V.

3. Système de commutation analogique bidirectionnel rapide selon la revendication 1 ou 2, dans lequel l'impulsion HF de tension élevée a une tension de crête de 100 V à 800 V et une durée inférieure à 1 microseconde.

4. Système de commutation analogique bidirectionnel rapide selon l'une quelconque des revendications précédentes, dans lequel le système est agencé de sorte que, lorsque à l'entrée, en même temps que l'impulsion de tension élevée, dans le même train que ladite impulsion de tension élevée ou en tant que réponse à ladite impulsion, apparaissent d'autres signaux externes de tension plus basse, dont les valeurs de crête ne dépassent pas un seuil $V_u$, d'un ordre de grandeur donné par l'expression

$$V_u = V_p/(1+R_1/R_3+R_1/R_2),$$

le système est capable de commuter lesdits signaux indépendamment de leur durée, c'est-à-dire que les signaux peuvent continuer à passer dans les deux sens, tant que l'état de conduction persiste à travers les ensembles de redresseurs ($GR_1$, $GR_2$), même si l'intervalle d'existence de ces signaux a dépassé le temps de stockage inverse desdits ensembles de redresseurs, $V_p$ représentant la tension de la source de tension ($V_p$) de la branche commune, $R_1$ représentant la valeur de la résistance de la branche commune et $R_1$ et $R_3$ représentant la valeur des résistances des branches latérales.

5. Système de commutation analogique bidirectionnel rapide selon l'une quelconque des revendications précédentes, dans lequel le contrôle de son état de conduction est effectué à partir de niveaux logiques TTL ou CMOS, en utilisant un inverseur logique avec une sortie à collecteur ouvert couplée par une diode (D) à la base d'un transistor bipolaire (T) qui fonctionne comme le commutateur de tension basse dans la branche commune des deux circuits secondaires.

6. Système de commutation analogique bidirectionnel rapide selon l'une quelconque des revendications précédentes, dans lequel, à chaque extrémité du canal conducteur principal (A - B), il y a un second condensateur ($C_2$) qui est connecté entre l'extrémité d'entrée dudit premier condensateur ($C_1$) et la masse, ledit second condensateur ($C_2$) étant d'une capacité inférieure d'au moins deux ordres de grandeur à la capacité dudit premier condensateur ($C_1$).

Figura 1

Figura 2